(19) Europäisches Patentamt
European Patent Office
Office européen des brevets

(11) **EP 3 792 653 B1**

(12) **EUROPÄISCHE PATENTSCHRIFT**

(45) Veröffentlichungstag und Bekanntmachung des Hinweises auf die Patenterteilung:
**26.01.2022 Patentblatt 2022/04**

(21) Anmeldenummer: **19196895.7**

(22) Anmeldetag: **12.09.2019**

(51) Internationale Patentklassifikation (IPC):
**G02B 26/12** (2006.01)  **G01S 7/481** (2006.01)
**G02B 5/09** (2006.01)

(52) Gemeinsame Patentklassifikation (CPC):
**G01S 7/4817; G01S 7/4812; G01S 7/4816; G02B 5/09; G02B 26/12**

(54) **LASERSCANNER**

LASER SCANNER

LECTEUR LASER

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**17.03.2021 Patentblatt 2021/11**

(73) Patentinhaber: **RIEGL Laser Measurement Systems GmbH**
**3580 Horn (AT)**

(72) Erfinder:
• **REICHERT, Rainer**
**3580 Horn (AT)**
• **RIEGER, Peter**
**3824 Grossau (AT)**
• **PFENNIGBAUER, Martin**
**3430 Tulln (AT)**
• **RIEGL, Johannes**
**3754 Trabenreith (AT)**

(74) Vertreter: **Weiser & Voith**
**Patentanwälte Partnerschaft**
**Kopfgasse 7**
**1130 Wien (AT)**

(56) Entgegenhaltungen:
EP-A1- 3 182 159    EP-A2- 2 293 013
AT-A1- 512 768    CN-U- 207 020 306
KR-A- 20180 089 625    US-A1- 2018 017 668

**Beschreibung**

Die vorliegende Erfindung betrifft einen Laserscanner, mit einem Gehäuse, einem Lasersender mit einer Sendeapertur zum Aussenden eines Sendestrahls, einem Laserempfänger mit einer Empfangsapertur zum Empfangen des von einer Umgebung reflektierten Sendestrahls als Empfangsstrahl, und einer Strahlablenkeinrichtung im Strahlengang der Sende- und Empfangsstrahlen in Form einer auf einer drehbaren Welle montierten Spiegelpyramide, deren Pyramidenachse die Drehachse und deren dazu geneigte Pyramidenseiten jeweils eine Spiegelfacette bilden, wobei der Lasersender und der Laserempfänger jeweils im wesentlichen parallel zur Drehachse der Spiegelpyramide auf diese gerichtet sind.

Derartige Laserscanner sind beispielsweise aus der EP 2 622 364 A1 oder der EP 3 182 159 A1 bekannt. Der axialparallel auf die sich drehende Spiegelpyramide gerichtete Sendestrahl wird von dieser periodisch über einen Abtastwinkelbereich verschwenkt, und der umgebungsreflektierte Empfangsstrahl wird auf demselben Wege zurückempfangen, d.h. die momentan zum Aussenden verwendete Spiegelfacette wird gleichzeitig zum Umlenken des aus derselben Richtung empfangenen Empfangsstrahls auf den Laserempfänger verwendet.

Nach dem Stand der Technik (z.B. EP 2 293 013 A1) ist die kreisrunde Empfangsapertur des Laserempfängers kleiner als ein Inkreis einer in Richtung der Drehachse betrachteten "aktiven" Spiegelfacette. Die aktive Spiegelfacette des Laserscanners ist dabei jeweils jene, über welche der Sendestrahl in seine Abtastrichtung abgelenkt wird, denn aus dieser Richtung wird auch der reflektierte Empfangsstrahl zurückempfangen und von der aktiven Spiegelfacette wieder zum Empfänger rückgeführt. Bei Drehung der Spiegelfacette wandert der Empfangsaperturkreis über die Kante zwischen zwei Spiegelfacetten und wird dadurch fortschreitend angeschnitten bzw. sein auf der aktiven Spiegelfacette liegenden Teil fortschreitend reduziert, was zu periodischen, winkelabhängigen Empfangsempfindlichkeitseinbußen des Laserscanners führt.

Die CN 207020306U zeigt einen Laserscanner gemäß dem Oberbegriff des Anspruchs 1. Die die Empfangsapertur bestimmende Sammellinse ist hier zwar etwas größer als eine Spiegelfacette, jedoch treten bei Drehung der Spiegelpyramide derselbe Anschneideeffekt und damit dieselben periodischen Empfindlichkeitseinbußen auf wie bei dem Laserscanner der EP 2 293 013 A1.

Die Erfindung setzt sich zum Ziel, einen Laserscanner mit verbesserter Empfangsempfindlichkeit und damit größerer Reichweite zu schaffen.

Dieses Ziel wird mit einem Laserscanner mit den Merkmalen des Anspruchs 1 erreicht. In Abkehr von den bekannten Lösungen wird nicht mehr die Empfangsapertur in die Spiegelfacette "eingepasst", sondern umgekehrt die Spiegelfacette in die Empfangsapertur. Da die Empfangsapertur erfindungsgemäß größer als die Spiegelfacette ist, wird so - zunächst einmal zumindest rund um die Mittellage des Sendestrahls auf der aktiven Spiegelfacette - diese zur Gänze für den Empfang ausgenützt.

Wenn die Spiegelpyramide mit Pyramidenseiten unterschiedlicher Neigung ausgestattet ist, u.zw. um Sendestrahlen in mehreren voneinander divergierenden Abtastfächern auszusenden, können die Spiegelfacetten in Richtung der Drehachse betrachtet unterschiedliche Größen haben. Dazu ist die Empfangsapertur in Richtung der Drehachse gesehen größer als die größte aller in Richtung der Drehachse betrachteten Spiegelfacetten, um den genannten Effekt in allen Abtastfächern zu erzielen.

Gemäß der Erfindung ist die Sammellinse in ihrem Überlappungsbereich mit den Spiegelfacetten im Flächenvergleich in Richtung der Drehachse gesehen zumindest so groß wie das Doppelte der größten aller in Richtung der Drehachse betrachteten Spiegelfacetten. Dadurch wird auch bei einem kleindurchmessrigen Sendestrahl, d.h. dessen Sendeapertur klein ist im Verhältnis zur jeweils aktiven Spiegelfacette, erreicht, dass diese über ihren gesamten Bewegungsweg, über den sie vom Sendestrahl getroffen wird, in Drehachsenrichtung betrachtet innerhalb der Empfangsapertur liegt. So wird die gesamte aktive Spiegelfacette für den Rückempfang des Empfangsstrahls während der gesamten Ablenkbewegung des Sendestrahls ausgenützt und dadurch die Empfangsempfindlichkeit des Laserscanners optimiert.

Gemäß einem bevorzugten Merkmal der Erfindung wird die Empfangsapertur jedoch wiederum auch nicht so groß gemacht, dass sie unnötig Lichtanteile von nicht-aktiven Spiegelfacetten mitempfängt. Bevorzugt ist daher die Sammellinse in Richtung der Drehachse gesehen in ihrem Überlappungsbereich mit den Spiegelfacetten im Flächenvergleich annähernd so groß wie das Doppelte der größten aller in Richtung der Drehachse betrachteten Spiegelfacetten. Dies optimiert die Empfangsempfindlichkeit unter größtmöglicher Unterdrückung von Störreflexionen.

Besonders günstig ist es, wenn die Sammellinse durch eine in Richtung der Drehachse gesehen annähernd kreisförmige Sammellinse, deren optische Achse in der Drehachse liegt, und eine der Sammellinse vorgesetzte Blende gebildet ist. Dies ergibt einen sehr einfachen, symmetrischen Aufbau, bei dem eine großdurchmessrige Sammellinse in Drehachsenrichtung gesehen gleichsam deckungsgleich über der Spiegelpyramide liegt, während die Blende zur Ausblendung der Störreflexionen von nicht-aktiven Spiegelfacetten dient. Beispielsweise hat, wenn die Spiegelpyramide vier Spiegelfacetten hat, die Blende in Richtung der Drehachse gesehen bevorzugt Halbkreisform und blendet somit jeweils zwei nicht-aktive Spiegelfacetten aus.

Alternativ könnte statt der Verwendung einer Blende für eine kreisförmige Sammellinse auch gleich eine in Richtung der Drehachse gesehen annähernd kreissektorförmige Sammellinse verwendet werden, deren optische Achse in der Drehachse liegt, insbesondere - für eine Spiegelpyramide mit vier Spiegelfacetten - eine halbkreisförmige Sammellinse.

Bevorzugt hat dabei der Laserempfänger ein im Brennpunkt der Sammellinse angeordnetes Empfangselement, besonders bevorzugt in Form eines Photomultipliers oder einer Lawinenphotodiode. Dieser Aufbau gewährleistet eine hohe Empfangsempfindlichkeit bei gleichzeitig großer Apertur des Laserempfängers.

Der Lasersender könnte direkt im Empfangsstrahlengang zwischen Spiegelpyramide und Laserempfänger liegen, z.B. wenn er ein sehr kleiner Halbleiterlaser ist, der die Empfangsapertur nur geringfügig abdeckt. Bevorzugt weist jedoch der Lasersender einen im Empfangsstrahlengang zwischen Spiegelpyramide und Laserempfänger liegenden Umlenkspiegel und einen auf den Umlenkspiegel gerichteten Laser auf, welcher außerhalb des Empfangsstrahlengangs liegt, um die Empfangsapertur möglichst wenig abzuschatten.

Gemäß einem weiteren bevorzugten Merkmal der Erfindung ist der Lasersender auf den pyramidenbasisseitigen Randbereich der Spiegelpyramide gerichtet. Dadurch wird der ausnützbare Bewegungsweg der aktiven Spiegelfacette, d.h. ihr Drehwinkel um die Drehachse der Spiegelpyramide, erhöht. Denn aufgrund der endlichen, nicht-punktförmigen Sendeapertur des Lasersenders ist der Sendestrahl nur über jenen Winkelbereich der Drehbewegung der aktiven Spiegelfacette ausnützbar, in dem er zur Gänze oder weitgehend zur Gänze auf dieser liegt, da sonst eine benachbarte Spiegelfacette mitgetroffen und der Sendestrahl dadurch gleichzeitig auch in eine andere, unerwünschte Richtung abgelenkt wird. Durch Verlagern des Sendestrahls auf den Randbereich der aktiven Spiegelfacette wird dessen ausnützbarer Drehwinkelbereich für das Aussenden des Sendestrahls maximiert.

Bevorzugt ist demgemäß der Durchmesser der Sendeapertur des Lasersenders auf Höhe einer Spiegelfacette kleiner als ein Viertel, besonders bevorzugt kleiner als ein Achtel, der Umfangserstreckung dieser Spiegelfacette im genannten Randbereich.

Ein weiterer Vorteil des randseitigen Bestrahlens der Spiegelpyramide mit dem Lasersender ergibt sich im Zusammenhang mit einem Austrittsfenster des Gehäuses für den Durchtritt der Sende- und Empfangsstrahlen. Insbesondere wenn das Gehäuse ein auf den Umfang der Spiegelpyramide gerichtetes Fenster aus transparentem Material für den Durchtritt der Sende- und Empfangsstrahlen aufweist, welches in Umfangsrichtung der Spiegelpyramide gesehen in zumindest drei zueinander abgewinkelte Abschnitte unterteilt ist, hat der mittlere Abschnitt bevorzugt mindestens eine solche Länge, dass der von der Spiegelpyramide abgelenkte Sendestrahl ausschließlich durch den mittleren Abschnitt hindurchtritt. Dadurch kann verhindert werden, dass der Sendestrahl von den Knicken des Glasfensters unkontrolliert bzw. unerwünscht gebrochen wird. In Verbindung mit der genannten vorteilhaften randseitigen Anstrahlung der Spiegelpyramide durch den Lasersender, welche den Abstrahlpunkt des Sendestrahls auf der aktiven Spiegelfacette dem dazu tangential liegenden Glasfenster näher bringt, kann dieser Mittelabschnitt besonders kurz gehalten werden, was eine besonders kompakte Bauweise des Laserscanners ermöglicht.

In jeder dieser Ausführungsformen kann die Spiegelpyramide regelmäßig sein, um den Sendestrahl in Form eines einzigen Abtastfächers auszusenden, oder wie erörtert zumindest zwei Pyramidenseiten der Spiegelpyramide können unterschiedliche Neigung haben, um den Sendestrahl in zumindest zwei unterschiedlichen Abtastfächern auszusenden.

Die Erfindung wird nachstehend anhand von in den Zeichnungen dargestellten Ausführungsbeispielen näher erläutert. In den Zeichnungen zeigen:

Fig. 1 den Laserscanner der Erfindung ohne Gehäuse in einer schematischen Perspektivansicht;
Fig. 2 den Laserscanner von Fig. 1 in einem Blockschaltbild mit schematisch eingezeichneten Strahlverläufen; und
die Fig. 3a - 3c die Spiegelpyramide und das Gehäusefenster des Laserscanners der Fig. 1 und 2 in drei verschiedenen Drehstellungen der Spiegelpyramide, u.zw. jeweils in Relation zu den Sende- und Empfangsaperturen von Lasersender und -empfänger in einer Draufsicht auf die Spiegelpyramide in Richtung ihrer Drehachse.

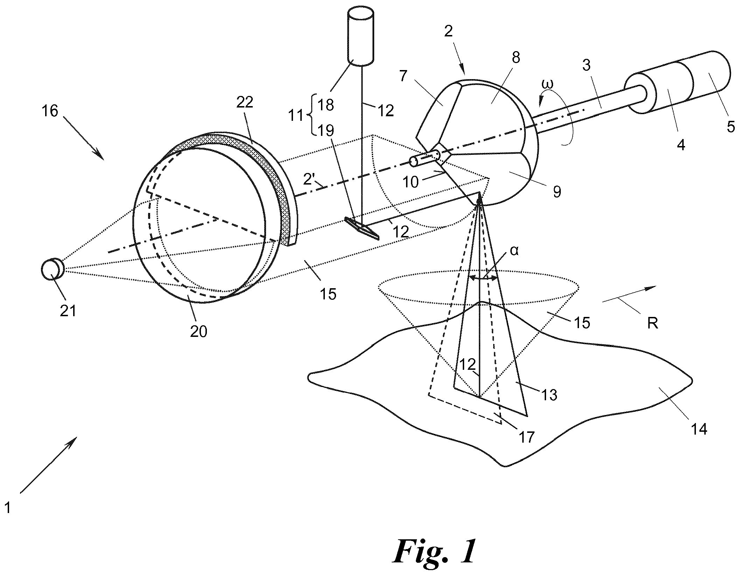

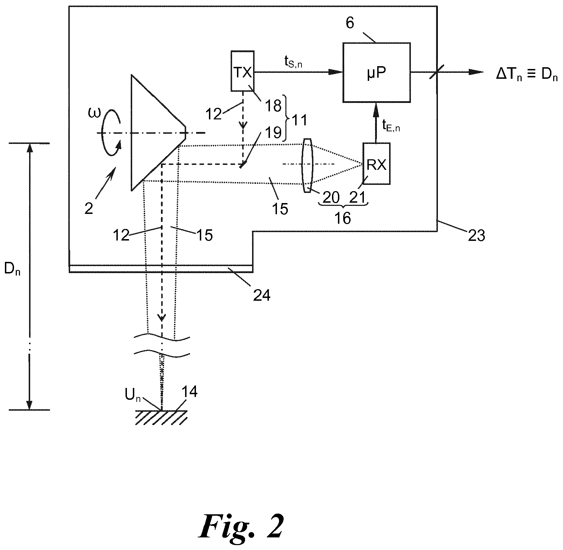

Fig. 1 zeigt schematisch einen Laserscanner 1, der eine Spiegelpyramide 2 umfasst, welche auf einer Welle 3 montiert ist und von einem Motor 4 gedreht wird. An den Motor 4 ist ein Drehwinkelkodierer bzw. -sensor 5 angeflanscht, welcher die aktuelle Stellung der Spiegelpyramide 2 misst bzw. kodiert und an eine Elektronikeinheit 6 (Fig. 2) signalisiert.

Die Spiegelpyramide 2 hat die Form einer vierseitigen Pyramide, deren Pyramidenachse 2' ihre Drehachse ist. Die zur Drehachse 2' geneigten Pyramidenseiten 7 - 10 bilden die Spiegelfacetten der Spiegelpyramide 2.

Es versteht sich, dass in der vorliegenden Beschreibung unter dem Begriff "Pyramidenform" bzw. "Spiegelpyramide" jede beliebige Art von Pyramide mit beliebiger polygonzugförmiger Grundfläche (Basis) verstanden wird, u.zw. sowohl gerade als auch "schiefe" Pyramiden (Pyramidenachse nicht senkrecht zur Grundachse), regelmäßige als auch unregelmäßige Pyramiden, spitze oder "stumpfe" Pyramiden ("Pyramidenstumpfe"), sowie auch solche Pyramiden, die an ihrer Spitze und/oder Basis beschnitten sind, wie die in den Fig. 1 und 2 gezeigten Pyramiden, deren Basis kreisförmig beschnitten ist, um den Luftwiderstand bei der Drehung zu verringern.

Auf die Spiegelpyramide 2 ist ein Lasersender 11 gerichtet, der einen Sendestrahl 12 auf die Spiegelfacetten 7 - 10 aussendet, u.zw. auf jeweils eine (die "aktive") Spiegelfacette 7 - 10 während deren Drehung, so dass der Sendestrahl 12 durch die Drehbewegung der Spiegelpyramide 2 periodisch über einen Abtastwinkel $\alpha$ verschwenkt wird, um einen Abtastfächer 13 zu bilden. Mit dem Abtastfächer 13 kann beispielsweise eine Oberfläche 14 "zeilenweise" abgetastet werden, wenn der Abtastfächer 13, z.B. der gesamte Laserscanner 1, in einer abtastebenenfremden Richtung R, z.B. normal zum Abtastfächer 13, über die Oberfläche 14 bewegt wird.

Die Reflexionen des Sendestrahls 12 bzw. Abtastfächers 13 von der Oberfläche 14 werden mit einem Laserempfänger 16 detektiert, der diese als Empfangsstrahl 15 - wieder über den Weg der Spiegelpyramide 2 - zurückempfängt, in elektrische Signale umwandelt und der Elektronikeinheit 6 zur Auswertung zuführt. Letztere steuert dazu den Lasersender 11 entsprechend an, z.B. getriggert, gepulst, moduliert usw., wie in der Technik bekannt.

Die hier betrachtete Spiegelpyramide 2 ist von einer speziellen Art, u.zw. hat zumindest eine der Pyramidenseiten 7 - 10 eine andere Neigung gegenüber der Drehachse 2' als die übrigen Pyramidenseiten 7 - 10. Dadurch ergeben sich bei der Drehung der Spiegelpyramide 2 nicht nur ein einziger Abtastfächer 13, sondern je nach Anzahl der Neigungen zwei, drei oder mehr Abtastfächer 13, 17 usw., die voneinander divergieren. Laserscanner dieser Art werden für unterschiedliche Anwendungszwecke benötigt, beispielsweise zur Erfassung von Hinterschneidungen der Oberfläche 14, für Kompensations- oder Differenzmessungen durch zweimaliges Abtasten derselben Oberfläche 14 od.dgl.

Der Lasersender 11 könnte direkt im Strahlengang des Empfangsstrahls 15 zwischen Spiegelpyramide 2 und Laserempfänger 16 liegen, beispielsweise wenn es sich um einen sehr kleinen Halbleiterlaser handelt. Im gezeigten Beispiel setzt sich der Lasersender 11 jedoch aus einem größeren Laser 18 außerhalb des Empfangsstrahlengangs und einem kleinen Umlenkspiegel 19 zusammen, welcher im Empfangsstrahlengang zwischen Spiegelpyramide 2 und Laserempfänger 16 liegt und den aus dem Laser 18 austretenden Laserstrahl 12 etwa parallel zur Drehachse 2' auf die Spiegelpyramide 2 richtet.

Der Laserempfänger 16 könnte grundsätzlich von jeder in der Technik bekannten Art sein, beispielsweise ein großformatiges fotoempfindliches Element, ein CCD-Chip usw. Im gezeigten Beispiel weist der Laserempfänger 16 (zumindest) eine Sammellinse 20 und ein dieser im Empfangsstrahlengang nachgeordnetes, im Brennpunkt der Sammellinse 20 angeordnetes Empfangselement 21 auf. Das Empfangselement 21 ist hochempfindlich, beispielsweise ein Photomultiplier oder eine Lawinenphotodiode.

Der Sammellinse 20 im Empfangsstrahlengang vorgeordnet ist eine (hier: halbkreisförmige) Blende 22, deren Funktion später noch näher erläutert wird. Die optische Achse der Sammellinse 20 fällt mit der Drehachse 2' der Spiegelpyramide 2 zusammen. Die Größe der Sammellinse 20 in Verbindung mit der Blende 22, d.h. abzüglich ihres von der Blende 22 ausgeblendeten Teils, und die Größe der jeweils aktiven Spiegelfacette 7 - 10, d.h. die kleinere der beiden Größen, bestimmt die Empfangsapertur des Laserempfängers 16. Anstelle der Kombination aus Sammellinse 20 und vorgeordneter Blende 22 könnte auch einfach die Sammellinse 20 beschnitten sein, d.h. der zuvor durch die Blende 22 definierte Teil der Sammellinse 20 "weggeschnitten" sein, wodurch die Sammellinse 20 Kreissektorform oder (hier:) Halbkreisform hat.

Wie in Fig. 2 gezeigt ist der Sendestrahl 12 beispielsweise ein gepulster Laserstrahl mit einzelnen Sendeimpulsen, die jeweils zu einem Sendeimpulszeitpunkt $t_{S,n}$ ausgesandt, nach Ablenkung durch die Spiegelpyramide 2 von einem Punkt $U_n$ der Oberfläche 14 reflektiert und nach Rückumlenkung über die Spiegelpyramide 2 im Laserempfänger 16 zu einem Empfangszeitpunkt $t_{E,n}$ empfangen werden. Aus der Laufzeit $\Delta T_n = t_{E,n} - t_{S,n}$ eines Impulses kann dann anhand der bekannten Beziehung

$$D_n = c \cdot \Delta T_n / 2 = c \cdot (t_{S,n} - t_{E,n})/2, \qquad\qquad (1)$$

mit

$t_{S,n}$ ... Sendezeitpunkt des Sende-Laserimpulses $S_n$,
$t_{E,n}$ ... Empfangszeitpunkt des Empfangs-Laserimpulses $E_n$, und
$c$ ......... Lichtgeschwindigkeit.

die Zielentfernung $D_n$ des Laserscanners 1 in der jeweiligen Senderichtung zum Umgebungsziel $U_n$ bestimmt werden.

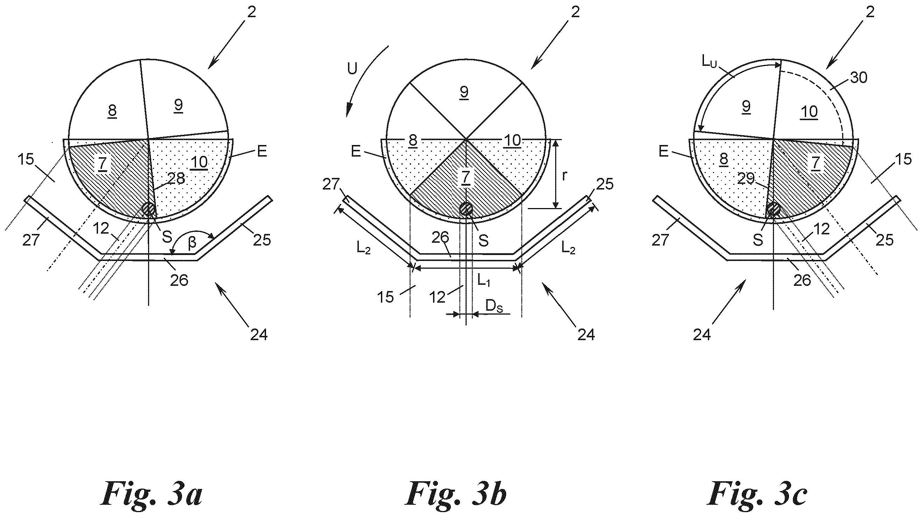

Fig. 2 zeigt den Laserscanner 1 von Fig. 1 - zweidimensional schematisch vereinfacht - eingebaut in ein Gehäuse 23. Für den Durchtritt der Sende- und Empfangsstrahlen 12, 15 besitzt das Gehäuse 23 ein Fenster 24 aus transparentem Material, z.B. Kunststoff oder Glas. Das Fenster 24 könnte beispielsweise eine große plane Glasscheibe sein oder Zylindersegmentform haben und sich in Umfangsrichtung U (Fig. 3b) der Spiegelpyramide 2 gesehen über den Abtastwinkel $\alpha$ erstrecken. Da einerseits ein planes Glasfenster 24 sehr groß sein müsste, um den Abtastwinkel $\alpha$ sowohl für den Sendestrahl 12 als auch den Empfangsstrahl 15 aufzunehmen, und andererseits die Herstellung zylindrisch gekrümmter Glasfenster aufwendig ist, ist das Glasfenster 14 wie dargestellt aus mehreren planen, zueinander abgewinkelten Abschnitten 25, 26, 27 zusammengesetzt, beispielsweise zusammengeklebt.

In den Fig. 3a - 3c sind drei Drehstellungen einer "aktiven" Spiegelfacette, das ist jeweils jene Spiegelfacette 7 - 10, welche gerade vom Sendestrahl 12 getroffen wird, hier die Spiegelfacette 7 (dünn schraffiert), bezüglich der Auftrefffläche bzw. Sendeapertur S (dick schraffiert) des Lasersenders 11 und der Empfangsapertur E (punktiert) des Laserempfängers 16 gezeigt, und zwar:

- in Fig. 3a jene Winkelstellung der aktiven Spiegelfacette 7, in welcher die Sendeapertur S die Kante 28 zwischen Spiegelfacette 10 und aktiver Spiegelfacette 7 gerade überschritten hat und somit zur Gänze auf der aktiven Spiegelfacette 7 liegt;
- in Fig. 3b die Mittelstellung, in welcher die aktive Spiegelfacette 7 soweit verdreht wurde, dass die Sendeapertur S in Umfangsrichtung U gesehen in der Mitte der aktiven Spiegelfacette 7 liegt; und
- in Fig. 3c jene Stellung, in welcher die Sendeapertur S gerade noch zur Gänze auf der aktiven Spiegelfacette 7 liegt, d.h. gerade bevor sie die Kante 29 zwischen der aktiven Spiegelfacette 7 und der angrenzenden Spielfacette 8 überschreitet und damit diese dann "aktiv" macht.

Wie ersichtlich ist der Lasersender 11 auf den Randbereich 30 der Spiegelpyramide 2 gerichtet, d.h. der Radialabstand r seines Auftreffpunktes bzw. der Sendeapertur S bezüglich der Drehachse 2' ist so weit maximiert, dass die Sendeapertur S in Radialrichtung gerade noch auf der aktiven Spiegelfacette 7 liegt. Ferner sollte der Durchmesser $D_S$ der Sendeapertur S möglichst klein im Verhältnis zur Umfangserstreckung $L_U$ der aktiven Spiegelfacette 7 im Randbereich 30 sein. Beispielsweise ist der Durchmesser $D_S$ der Sendeapertur S kleiner als ein Viertel, insbesondere kleiner als ein Achtel, der Umfangserstreckung $L_U$ der jeweils aktiven Spiegelfacette 7 - 10 in deren Randbereich 30.

Um zu vermeiden, dass der Sendestrahl 12 während der Abtastbewegung über den Abtastwinkel $\alpha$ einen der Knicke zwischen den Abschnitten 25 und 26 bzw. 26 und 27 überstreicht und dort unregelmäßig gebrochen bzw. versetzt wird, hat der mittlere Abschnitt 26 eine solche Länge $L_1$ in Umfangsrichtung U der Spiegelpyramide 2 gesehen, dass der von der Spiegelpyramide 2 abgelenkte Sendestrahl 12 ausschließlich durch den mittleren Abschnitt 26 hindurchtritt. Es versteht sich, dass die Länge $L_1$ dabei vom Abstand der Spiegelpyramide 2 zum mittleren Abschnitt 26, der Neigung der Spiegelfacetten 7 - 10 zur Drehachse 2' und dem Radialabstand r des Auftreffpunkt des Sendestrahls 12 auf der Spiegelpyramide 2 zur Drehachse 2' abhängt. Je näher das Glasfenster 14 zur Spiegelpyramide 2 liegt und je weiter radial außen der Sendestrahl 12 auf die Spiegelpyramide 2 auftrifft, desto kürzer kann die Länge $L_1$ des mittleren Abschnitts 26 und damit insgesamt das Glasfenster 14 sein.

Die Längen $L_2$ der äußeren Abschnitte 25, 27 und deren Winkel $\beta$ zum mittleren Abschnitt 26 werden möglichst so gewählt, dass der vom Umgebungspunkt $U_n$ diffus, d.h. aufgeweitet, reflektierte Empfangsstrahl 15 die gesamte aktive Spiegelfacette 7, die gerade vom Sendestrahl 12 getroffen wird, auch noch in den beiden äußersten Endstellungen des Sendestrahls 12 auf der aktiven Spiegelfacette 7, wie sie in den Fig. 3a und 3c dargestellt sind, treffen kann.

Gemäß den Fig. 3a - 3c ist die Empfangsapertur E (punktiert) des Laserempfängers 16 etwa so groß wie das Doppelte einer der Spiegelfacetten 7 - 10 (dünn schraffiert) in Richtung der Drehachse 2' gesehen, d.h. jeweils in einer Projektion in Richtung der Drehachse 2' auf eine zur Drehachse normale Projektionsebene (hier: die Zeichnungsebene). Wenn die Spiegelfacetten 7 - 10 der Spiegelpyramide 2 unterschiedliche Neigungen haben, um verschiedene Abtastfächer 13, 17 zu erzeugen, sind sie in Richtung der Drehachse 2' betrachtet in der Regel unterschiedlich groß. In diesem Fall ist die Empfangsapertur E des Laserempfängers 16 bevorzugt etwa so groß wie das Doppelte der größten aller in Richtung der Drehachse 2' betrachteten Spiegelfacetten 7 - 10.

Durch die Verwendung einer derart großen Empfangsapertur E kann der Laserempfänger 16 in jeder der in den Fig. 3a - 3c gezeigten Stellungen der Spiegelpyramide 2 jeweils die gesamten von einer aktiven Spiegelfacette, wie hier der Spiegelfacette 7, zurückempfangenen und umgelenkten Empfangsstrahlen 15 ausnützen und empfangen. Beispielsweise wird dies durch die in Fig. 1 gezeigte Sammellinse 20 erreicht, die in den Draufsichten der Fig. 3a und 3c jeweils zwei nebeneinanderliegende der Spiegelfacetten 7 - 10 im Wesentlichen überlappt. Dadurch ist gewährleistet, dass selbst in den beiden Endstellungen der Sendeapertur S auf der aktiven Spiegelfacette 7 (Fig. 3a und 3c) jeweils die gesamte Fläche der aktiven Spiegelfacette 7 für den Empfang des Empfangsstrahls 15 ausgenützt werden kann, ohne diesen zu beschneiden.

Grundsätzlich könnte die Empfangsapertur E (in Drehachsenrichtung 2' betrachtet) auch größer als das Doppelte der größten Spiegelfacette sein, also beispielsweise die gesamte Spiegelpyramide 2 abdecken, d.h. die Blende 22 entfallen. Dadurch wird die Empfangsempfindlichkeit des Laserscanners 1 jedoch nicht weiter erhöht, denn nur Empfangsstrahlen 15, die jeweils aktive Spiegelfacette 7 treffen und aus der interessierenden Aussenderichtung des Sendestrahls 12 einfallen, sind Nutzstrahlen. Eine Vergrößerung der Empfangsapertur E über die in Drehachsenrichtung 2' betrachtete Fläche zweier Spiegelfacetten 7 - 10 hinaus, beispielsweise durch Weglassen der Blende 22, vergrößert daher nicht mehr die Empfangsempfindlichkeit, sondern kann im Gegenteil zu Einstreuen von Störsignalen in den Laserempfänger 16 führen, beispielsweise von internen Reflexionen der Sende- und Empfangsstrahlen 12, 15 im Gehäuse 23, wenn diese auf die rückseitigen, nicht-aktiven Spiegelfacetten, das sind die Spiegelfacetten 8, 9 in Fig. 3a, 9 in Fig. 3b und 9, 10 in Fig. 3c, auftreffen.

In einer nicht-beanspruchten Ausführungsform könnte die Empfangsapertur E auch in einem Bereich zwischen dem Einfachen der in Drehachsenrichtung 2' betrachteten Fläche einer Spiegelfacette 7 - 10 (insbesondere der größten derselben) und dem genannten Doppelten liegen, mit entsprechender Verringerung der Empfangsempfindlichkeit des Laserscanners 1 nahe den Endstellungen der Fig. 3a und 3c, weil dann die Empfangsapertur E nicht mehr die gesamte aktive Spiegelfacette 7 erfassen kann bzw. diese "anschneidet". Dennoch ergibt sich auch hier eine Vergrößerung der Empfangsempfindlichkeit des Laserscanners 1 gegenüber herkömmlichen Laserscannern, u.zw. zumindest rund um die Mittelstellung von Fig. 3b.

Die Steigerung der Empfangsempfindlichkeit des Laserscanners 1 kann für eine Steigerung seiner Reichweite ausgenützt werden, sodass auch ferne Umgebungsziele $U_n$, welche nur schwache Empfangsstrahlen 15 reflektieren, vermessen werden können.

Die Erfindung ist nicht auf die dargestellten Ausführungsformen beschränkt, sondern umfasst alle Varianten, Modifikationen und deren Kombinationen, die in den Rahmen der angeschlossen Ansprüche fallen.

**Patentansprüche**

1. Laserscanner (1), mit

   einem Gehäuse (23),
   einem Lasersender (11) mit einer Sendeapertur (S) zum Aussenden eines Sendestrahls (12),
   einem Laserempfänger (16) zum Empfangen des von einer Umgebung (12) reflektierten Sendestrahls (12) als Empfangsstrahl (15), und
   einer Strahlablenkeinrichtung im Strahlengang der Sende-und Empfangsstrahlen in Form einer auf einer drehbaren Welle (3) montierten Spiegelpyramide (2), deren Pyramidenachse die Drehachse (2') und deren dazu geneigte Pyramidenseiten jeweils eine Spiegelfacette (7 - 10) bilden,
   wobei der Lasersender (11) und der Laserempfänger (16) jeweils im wesentlichen parallel zur Drehachse (2') der Spiegelpyramide (2) auf diese gerichtet sind, und
   wobei der Laserempfänger (16) zumindest eine der Spiegelpyramide (2) im Empfangsstrahlengang nachgeordnete Sammellinse (20) aufweist,
   **dadurch gekennzeichnet,**
   **dass** die Sammellinse (20) in Richtung der Drehachse (2') gesehen in ihrem Überlappungsbereich mit den Spiegelfacetten (7 - 10) im Flächenvergleich zumindest so groß wie das Doppelte der größten aller in Richtung der Drehachse (2') betrachteten Spiegelfacetten (7 - 10) ist.

2. Laserscanner nach Anspruch 1, **dadurch gekennzeichnet, dass** die Sammellinse (20) in Richtung der Drehachse (2') gesehen in ihrem Überlappungsbereich mit den Spiegelfacetten (7 - 10) im Flächenvergleich annähernd so groß wie das Doppelte der größten aller in Richtung der Drehachse (2') betrachteten Spiegelfacetten (7 - 10) ist.

3. Laserscanner Anspruch 1 oder 2, **dadurch gekennzeichnet, dass** die Sammellinse durch eine in Richtung der Drehachse (2') gesehen annähernd kreisförmige Sammellinse (20), deren optische Achse in der Drehachse (2') liegt, und eine der Sammellinse (20) vorgesetzte Blende (22) gebildet ist.

4. Laserscanner nach Anspruch 3, **dadurch gekennzeichnet, dass** die Spiegelpyramide (2) vier Spiegelfacetten (7 - 10) und die Blende (22) in Richtung der Drehachse (2') gesehen Halbkreisform hat.

5. Laserscanner nach Anspruch 1 oder 2, **dadurch gekennzeichnet, dass** die Sammellinse durch eine in Richtung der Drehachse (2') gesehen annähernd kreissektorförmige Sammellinse (20) gebildet ist, deren optische Achse in der Drehachse (2') liegt.

6. Laserscanner nach Anspruch 5, **dadurch gekennzeichnet, dass** die Spiegelpyramide (2) vier Spiegelfacetten (7 - 10) und die Sammellinse (20) in Richtung der Drehachse (2') gesehen Halbkreisform hat.

7. Laserscanner nach einem der Ansprüche 3 bis 6, **dadurch gekennzeichnet, dass** der Laserempfänger (16) ein im Brennpunkt der Sammellinse (20) angeordnetes Empfangselement (21) hat, bevorzugt in Form eines Photomultipliers oder einer Lawinenphotodiode.

8. Laserscanner nach einem der Ansprüche 1 bis 7, **dadurch gekennzeichnet, dass** der Lasersender (11) einen im Empfangsstrahlengang zwischen Spiegelpyramide (2) und Laserempfänger (16) liegenden Umlenkspiegel (19) und einen auf den Umlenkspiegel (19) gerichteten Laser (18) aufweist, welcher außerhalb des Empfangsstrahlengangs liegt.

9. Laserscanner nach einem der Ansprüche 1 bis 8, **dadurch gekennzeichnet, dass** der Lasersender (11) auf den pyramidenbasisseitigen Randbereich (30) der Spiegelpyramide (2) gerichtet ist.

10. Laserscanner nach Anspruch 9, **dadurch gekennzeichnet, dass** der Durchmesser ($D_S$) der Sendeapertur (S) des Lasersenders (11) auf Höhe einer Spiegelfacette (7 - 10) kleiner als ein Viertel, bevorzugt kleiner als ein Achtel, der Umfangserstreckung ($L_U$) dieser Spiegelfacette (7 - 10) im genannten Randbereich (30) ist.

11. Laserscanner nach einem der Ansprüche 1 bis 10, **dadurch gekennzeichnet, dass** das Gehäuse (23) ein auf den Umfang der Spiegelpyramide (2) gerichtetes Fenster (24) aus transparentem Material für den Durchtritt der Sende- und Empfangsstrahlen (12, 15) aufweist, welches in Umfangsrichtung (U) der Spiegelpyramide (2) gesehen in zumindest drei zueinander abgewinkelte Abschnitte (25 - 27) unterteilt ist, wobei der mittlere Abschnitt (26) mindestens eine solche Länge ($L_1$) hat, dass der von der Spiegelpyramide (2) abgelenkte Sendestrahl (12) ausschließlich durch den mittleren Abschnitt (26) hindurchtritt.

12. Laserscanner nach einem der Ansprüche 1 bis 11, **dadurch gekennzeichnet, dass** zumindest zwei Spiegelfacetten (7 - 10) der Spiegelpyramide (2) unterschiedliche Neigung haben.

**Claims**

1. A laser scanner (1), with

   a housing (23),
   a laser transmitter (11) with a transmission aperture (S) for emitting a transmission beam (12),
   a laser receiver (16) for receiving the transmission beam (12) reflected from an environment (12) as a reception beam (15), and
   a beam deflection device in the beam bath of the transmission and reception beams in form of a mirror pyramid (2) mounted on a rotatable shaft (3), the mirror pyramid's pyramid axis forming the rotation axis (2') and the mirror pyramid's pyramid sides inclined thereto each forming a mirror facet (7 - 10),
   wherein the laser transmitter (11) and the laser receiver (16) are each directed towards the mirror pyramid (2) substantially in parallel to the rotation axis (2'), and
   wherein the laser receiver (16) comprises at least one collective lens (20) arranged downstream of the mirror pyramid (2) in the reception beam path,
   **characterized in that**
   the collective lens (20) is, when seen in the direction of the rotation axis (2'), in its overlapping region with the mirror facets (7 - 10) at least as large in area as twice of the largest of all mirror facets (7 - 10) seen in the direction of the rotation axis (2').

2. The laser scanner according to claim 1, **characterized in that** the collective lens (20) is, when seen in the direction of the rotation axis (2'), in its overlapping region with the mirror facets (7 - 10) approximately as large in area as twice of the largest of all mirror facets (7 - 10) seen in the direction of the rotation axis (2').

3. The laser scanner according to claim 1 or 2, **characterized in that** the collective lens is formed by a collective lens (20) with an approximately circular shape, when seen in the direction of the rotation axis (2'), wherein the optical axis of the collective lens (20) lies in the rotation axis (2'), and by a diaphragm (22) disposed in front of the collective lens (20).

4. The laser scanner according to claim 3, **characterized in that** the mirror pyramid (2) has four mirror facets (7 - 10) and the diaphragm (22) has the shape of a semi-circle when seen in the direction of the rotation axis (2').

5. The laser scanner according to claim 1 or 2, **characterized in that** the collective lens is formed by a collective lens (20) with approximately a shape of a sector of a circle, when seen in the direction of the rotation axis (2'), wherein the optical axis of the collective lens (20) lies in the rotation axis (2').

6. The laser scanner according to claim 5, **characterized in that** the mirror pyramid (2) has four mirror facets (7 - 10) and the collective lens (20) has the shape of a semi-circle, when seen in the direction of the rotation axis (2').

7. The laser scanner according to any one of claims 3 to 6, **characterized in that** the laser receiver (16) has a receiving element (21) disposed in the focus of the collective lens (20), preferably in the form of a photomultiplier or an avalanche photo diode.

8. The laser scanner according to any one of claims 1 to 7, **characterized in that** the laser transmitter (11) comprises a deflection mirror (19) arranged in the reception beam path between the mirror pyramid (2) and the laser receiver (16), and a laser (18) directed towards the deflection mirror (19) and arranged outside of the reception beam path.

9. The laser scanner according to any one of claims 1 to 8, **characterized in that** the laser transmitter (11) is directed towards a border region (30) of the pyramid basis side of the mirror pyramid (2).

10. The laser scanner according to claim 9, **characterized in that** the diameter ($D_S$) of the transmission aperture (S) of the laser transmitter (11) is, at the level of a mirror facet (7 - 10), smaller than a quarter, preferably smaller than an eighth, of the circumferential extension ($L_U$) of this mirror facet (7 - 10) in said border region (30).

11. The laser scanner according to any one of claims 1 to 10, **characterized in that** the housing (23) comprises a window (24) made of a transparent material and directed towards the perimeter of the mirror pyramid (2) for the passage of the transmission and reception beams (12, 15), which window, when seen in circumferential direction (U) of the mirror pyramid (2), is divided into at least three sections (25 - 27) tilted with respect to each other, wherein the middle section (26) has at least such a length ($L_1$) that the transmission beam (12) deflected from the mirror pyramid (2) passes only through the middle section (26).

12. The laser scanner according to any one of claims 1 to 11, **characterized in that** at least two mirror facets (7 - 10) of the mirror pyramid (2) have a different inclination.

## Revendications

1. Scanner laser (1) avec

   un boitier (23),
   un émetteur laser (11) avec une ouverture d'émission (S) pour l'émission d'un faisceau d'émission (12),
   un récepteur laser (16) pour la réception d'un faisceau d'émission (12) réfléchi par un environnement (12) en tant que faisceau de réception (15), et
   un dispositif de déviation de faisceau dans le trajet des faisceaux d'émission et de réception sous la forme d'une pyramide miroir (2) montée sur un arbre (3) rotatif, où l'axe de pyramide de laquelle forme l'axe de rotation (2') et les faces de pyramide de laquelle inclinées par rapport à celui-ci forment respectivement une facette de miroir (7 - 10),
   dans lequel l'émetteur laser (11) et le récepteur laser (16) sont respectivement orientés sensiblement de manière parallèle par rapport à l'axe de rotation (2') de la pyramide miroir (2) sur celle-ci, et
   dans lequel le récepteur laser (16) présente au moins une lentille collectrice (20) disposée après la pyramide miroir (2) dans le trajet du faisceau de réception,
   **caractérisé en ce**
   **que** la lentille collectrice (20), vue dans la direction de l'axe de rotation (2'), est au moins aussi grande au niveau de la surface dans sa zone de superposition avec les facettes de miroir (7 - 10) que le double de la plus grande de toutes les facettes de miroir (7 - 10) considérées dans la direction de l'axe de rotation (2').

2. Scanner laser selon la revendication 1, **caractérisé en ce que** la lentille collectrice (20), vue dans la direction de l'axe de rotation (2'), est a peu près aussi grande au niveau de la surface dans sa zone de superposition avec les facettes de miroir (7 - 10) que le double de la plus grande de toutes les facettes de miroir (7 - 10) considérées dans la direction de l'axe de rotation (2').

3. Scanner laser selon la revendication 1 ou 2, **caractérisé en ce que** la lentille collectrice (20) est formée par une lentille collectrice (20) approximativement en forme de cercle, vue dans la direction de l'axe de rotation (2'), où l'axe optique du lentille collectrice (20) se situe dans l'axe de rotation (2'), et par un diaphragme (22) disposé avant la lentille collectrice (20).

**4.** Scanner laser selon la revendication 3, **caractérisé en ce que** la pyramide miroir (2) a quatre facettes de miroir (7 - 10) et le diaphragme (22) a la forme d'un demi cercle, vu dans la direction de l'axe de rotation (2').

**5.** Scanner laser selon la revendication 1 ou 2, **caractérisé en ce que** la lentille collectrice est formée par une lentille collectrice (20) approximativement en forme de secteur de cercle, vu dans la direction de l'axe de rotation (2'), où l'axe optique du lentille collectrice (20) se situe dans l'axe de rotation (2').

**6.** Scanner laser selon la revendication 5, **caractérisé en ce que** la pyramide miroir (2) a quatre facettes de miroir (7 - 10) et la lentille collectrice (20) a la forme d'un demi cercle, vu dans la direction de l'axe de rotation (2').

**7.** Scanner laser selon l'une des revendications 3 à 6, **caractérisé en ce que** le récepteur laser (16) a un élément de réception (21) disposé au foyer de la lentille collectrice (20), de préférence sous la forme d'un photomultiplicateur ou d'une photodiode à avalanche.

**8.** Scanner laser selon l'une des revendications 1 à 7, **caractérisé en ce que** l'émetteur laser (11) présente un miroir de déviation (19) se situant dans le trajet du faisceau de réception entre la pyramide miroir (2) et le récepteur laser (16), et un laser (18) orienté sur le miroir de déviation (19) et se situant à l'extérieur du trajet du faisceau de réception.

**9.** Scanner laser selon l'une des revendications 1 à 8, **caractérisé en ce que** l'émetteur laser (11) est orienté sur la zone de bord (30) de la base de pyramide de la pyramide miroir (2) .

**10.** Scanner laser selon la revendication 9, **caractérisé en ce que** le diamètre ($D_S$) de l'ouverture d'émission (S) de l'émetteur laser (11), au niveau d'une facette de miroir (7 - 10), est plus petit qu'un quart, de préférence plus petit qu'un huitième, de l'extension périphérique ($L_U$) de cette facette de miroir (7 - 10) dans ladite zone de bord (30).

**11.** Scanner laser selon l'une des revendications 1 à 10, **caractérisé en ce que** le boitier (23) présente une fenêtre (24) à base d'un matériau transparent orientée sur le périmètre de la pyramide miroir (2) pour le passage des faisceaux d'émission et de réception (12, 15), laquelle fenêtre, vue dans la direction périphérique (U) de la pyramide miroir (2), est divisée en au moins trois segments (25 - 27) coudé l'un par rapport l'autre, où le segment médian (26) a une telle longueur ($L_1$) que le faisceau d'émission (12) dévié par la pyramide miroir (2) passe exclusivement le segment médian (26).

**12.** Scanner laser selon l'une des revendications 1 à 11, **caractérisé en ce qu'**au moins deux facettes de miroir (7 - 10) de la pyramide miroir (2) ont une inclinaison différente.

*Fig. 1*

*Fig. 2*

EP 3 792 653 B1

EP 3 792 653 B1

**Fig. 3a**        **Fig. 3b**        **Fig. 3c**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 2622364 A1
- EP 3182159 A1
- EP 2293013 A1
- CN 207020306 U